(19) Europäisches Patentamt
European Patent Office
Office européen des brevets

(11) **EP 4 564 417 A1**

(12) **EUROPÄISCHE PATENTANMELDUNG**

(43) Veröffentlichungstag:
**04.06.2025 Patentblatt 2025/23**

(21) Anmeldenummer: **23213098.9**

(22) Anmeldetag: **29.11.2023**

(51) Internationale Patentklassifikation (IPC):
*H01L 23/00* (2006.01)    *H01L 23/373* (2006.01)
*H01L 23/498* (2006.01)    *H01L 23/538* (2006.01)
*H01L 23/64* (2006.01)    *H01L 25/07* (2006.01)
*H01L 25/18* (2023.01)    *H02M 7/00* (2006.01)

(52) Gemeinsame Patentklassifikation (CPC):
**H01L 24/49; H01L 23/49811; H01L 23/49844;
H01L 23/5386; H01L 23/64; H01L 25/072;**
H01L 24/39; H02M 3/003; H02M 7/003

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft
80333 München (DE)**

(72) Erfinder:
• **Roppelt, Bernd
96173 Unterhaid (DE)**

• **Schmenger, Jens
91301 Forchheim (DE)**
• **Höhne, Silvio
91301 Forchheim (DE)**
• **Käsbauer, Michael
90453 Nürnberg (DE)**
• **Maier, Lukas
91077 Neunkirchen am Brand (DE)**

(74) Vertreter: **Siemens Patent Attorneys
Postfach 22 16 34
80506 München (DE)**

(54) **HALBLEITERANORDNUNG MIT EINEM ERSTEN HALBLEITERELEMENT UND EINEM SUBSTRAT**

(57)   Die Erfindung betrifft ein Halbleiteranordnung (2) mit einem ersten Halbleiterelement (4) und einem Substrat (6), wobei das Substrat (6) eine Substratmetallisierung (14) mit voneinander elektrisch isoliert angeordneten Leitungsabschnitten (12, 16, 18, 42, 44) aufweist, wobei das erste Halbleiterelement (4), insbesondere stoffschlüssig, mit einem ersten Leitungsabschnitt (12) der Substratmetallisierung (14) verbunden ist, wobei das erste Halbleiterelement (4) auf einer dem Substrat (6) abgewandten Seite eine Kontaktfläche (8) aufweist, wobei ein zweiter Leitungsabschnitt (16) und ein dritter Leitungsabschnitt (18) der Substratmetallisierung (14) auf gegenüberliegenden Seiten des ersten Halbleiterelements (4) angeordnet sind, wobei Verdrahtungselemente (22, 24, 32, 34, 36, 38) jeweils elektrisch und mechanisch mit dem zweiten Leitungsabschnitt (16), der Kontaktfläche (8) des ersten Halbleiterelements (4) und dem dritten Leitungsabschnitt (18) verbunden sind. Um eine verbesserte Zuverlässigkeit zu erreichen, wird vorgeschlagen, dass der zweite Leitungsabschnitt (16) und der dritte Leitungsabschnitt (18) so konfiguriert sind, dass ein während eines Betriebes der Halbleiteranordnung (2) zwischen dem zweiten Leitungsabschnitt (16) und dem dritten Leitungsabschnitt (18) über die Verdrahtungselemente (22, 24, 32, 34, 36, 38) fließender Strom (IL) einseitig auf diagonal gegenüberliegenden Seiten zu- bzw. abfließt.

FIG 1

**Beschreibung**

Die Erfindung betrifft eine Halbleiteranordnung mit einem ersten Halbleiterelement und einem Substrat.

Ferner betrifft die Erfindung einen Stromrichter mit mindestens einer derartigen Halbleiteranordnung.

Überdies betrifft die Erfindung ein Verfahren zur Herstellung einer Halbleiteranordnung mit einem ersten Halbleiterelement und einem Substrat.

Darüber hinaus betrifft die Erfindung ein Computerprogrammprodukt, umfassend Befehle, die bei einer Ausführung des Programms durch einen Computer diesen veranlassen, ein Verhalten einer derartigen Halbleiteranordnung zu simulieren.

Eine derartige Halbleiteranordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden. Transistoren sind beispielsweise als Insulated-Gate-BipolarTransistoren (IGBTs), Feldeffekttransistoren oder Bipolartransistoren ausgeführt. Die Halbleiterelemente einer Halbleiteranordnung sind üblicherweise über Verdrahtungselemente auf einem Substrat kontaktiert. Derartige Verdrahtungselemente können unter anderem Bonddrähte und/oder Bondbänder umfassen. Insbesondere Lastkontakte eines Halbleiterelements, unter anderem ein Emitter-Kontakt eines IGBTs, sind üblicherweise mit einer Mehrzahl von Verdrahtungselementen auf dem Substrat kontaktiert.

Die Offenlegungsschrift WO 2022/002464 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind. Eine dem Substrat abgewandte Seite der Leistungshalbleiter ist jeweils über eine Bondverbindung mit einer oberen Metallisierung des Substrats verbunden.

Während des Betriebes der Halbleiterelemente können sich Verdrahtungselemente vom Lastkontakt ablösen, was zu einem Ausfall der Halbleiteranordnung führt. Eine robustere Verdrahtung führt zu einer verbesserten Zuverlässigkeit der Halbleiteranordnung.

Vor diesem Hintergrund besteht die Aufgabe der vorliegenden Erfindung darin, eine Halbleiteranordnung anzugeben, welche eine verbesserte Zuverlässigkeit aufweist.

Die Aufgabe wird erfindungsgemäß gelöst durch eine Halbleiteranordnung mit einem ersten Halbleiterelement und einem Substrat, wobei das Substrat eine Substratmetallisierung mit voneinander elektrisch isoliert angeordneten Leitungsabschnitten aufweist, wobei das erste Halbleiterelement, insbesondere stoffschlüssig, mit einem ersten Leitungsabschnitt der Substratmetallisierung verbunden ist, wobei das erste Halbleiterelement auf einer dem Substrat abgewandten Seite eine Kontaktfläche aufweist, wobei ein zweiter Leitungsabschnitt und ein dritter Leitungsabschnitt der Substratmetallisierung auf gegenüberliegenden Seiten des ersten Halbleiterelements angeordnet sind, wobei Verdrahtungselemente jeweils elektrisch und mechanisch mit dem zweiten Leitungsabschnitt, der Kontaktfläche des ersten Halbleiterelements und dem dritten Leitungsabschnitt verbunden sind, wobei der zweite Leitungsabschnitt und der dritte Leitungsabschnitt so konfiguriert sind, dass ein während eines Betriebes der Halbleiteranordnung zwischen dem zweiten Leitungsabschnitt und dem dritten Leitungsabschnitt über die Verdrahtungselemente fließender Strom einseitig auf diagonal gegenüberliegenden Seiten zu- bzw. abfließt.

Ferner wird die Aufgabe erfindungsgemäß gelöst durch einen Stromrichter mit mindestens einer derartigen Halbleiteranordnung.

Überdies wird die Aufgabe erfindungsgemäß gelöst durch ein Verfahren zur Herstellung einer Halbleiteranordnung mit einem ersten Halbleiterelement und einem Substrat, wobei das Substrat eine Substratmetallisierung mit voneinander elektrisch isoliert angeordneten Leitungsabschnitten aufweist, wobei das erste Halbleiterelement, insbesondere stoffschlüssig, mit einem ersten Leitungsabschnitt der Substratmetallisierung verbunden wird, wobei das erste Halbleiterelement auf einer dem Substrat abgewandten Seite eine Kontaktfläche aufweist, wobei ein zweiter Leitungsabschnitt und ein dritter Leitungsabschnitt der Substratmetallisierung auf gegenüberliegenden Seiten des ersten Halbleiterelements angeordnet werden, wobei Verdrahtungselemente jeweils elektrisch und mechanisch mit dem zweiten Leitungsabschnitt, der Kontaktfläche des ersten Halbleiterelements und dem dritten Leitungsabschnitt verbunden werden, wobei der zweite Leitungsabschnitt und der dritte Leitungsabschnitt so konfiguriert werden, dass ein während eines Betriebes der Halbleiteranordnung zwischen dem zweiten Leitungsabschnitt und dem dritten Leitungsabschnitt über die Verdrahtungselemente fließender Strom einseitig auf diagonal gegenüberliegenden Seiten zu- bzw. abfließt.

Darüber hinaus wird die Aufgabe erfindungsgemäß gelöst durch ein Computerprogrammprodukt, umfassend Befehle, die bei einer Ausführung des Programms durch einen Computer diesen veranlassen, ein, insbesondere thermisches, mechanisches und/oder elektrisches, Verhalten einer derartigen Halbleiteranordnung zu simulieren.

Die in Bezug auf die Halbleiteranordnung nachstehend angeführten Vorteile und bevorzugten Ausgestaltungen lassen sich sinngemäß auf den Stromrichter, das Verfahren und das Computerprogrammprodukt übertragen.

Der Erfindung liegt die Überlegung zugrunde, die Zuverlässigkeit einer Halbleiteranordnung dadurch zu verbessern, dass die Wahrscheinlichkeit für einen Ausfall während des Betriebes der Halbleiteranordnung durch von einem Halbleiterelement abgelöste Verdrahtungselemente signifikant verringert wird. Eine derartige Ablösung kann unter anderem durch unterschiedliche Belastung von Verdrahtungselementen bei ungleichmäßigem Stromfluss zustande kommen. Eine derartige Halbleiteranordnung weist ein Substrat mit einer strukturierten Substratmetallisierung auf, welche voneinander elektrisch isoliert angeordnete Leitungsabschnitte umfasst. Ein erstes Halbleiterelement, beispielsweise ein vertikaler Transistor wie ein IGBT, ist, insbesondere stoffschlüssig, mit einem ersten Leitungsabschnitt der Substratmetallisierung verbunden. Die stoffschlüssige Verbindung wird beispielsweise durch Löten, Sintern oder adhäsiv hergestellt. Ferner weist das Halbleiterelement auf einer dem Substrat abgewandten Seite eine Kontaktfläche auf, welche über Verdrahtungselemente mit der Substratmetallisierung verbunden ist. Beispielsweise ist das Halbleiterelement als IGBT ausgeführt, der kollektorseitig auf den ersten Leitungsabschnitt der Substratmetallisierung gelötet oder gesintert ist, während er emitterseitig über die Verdrahtungselemente mit der Substratmetallisierung verbunden ist. Die Verdrahtungselemente sind beispielsweise als Bonddrähte oder Bondbänder ausgeführt, wobei durch Ultraschall-Bondverbindungen die Verbindung zwischen der Substratmetallisierung und der Kontaktfläche des Halbleiterelements herstellbar ist. Die Verdrahtungselemente sind jeweils mit einem zweiten Leitungsabschnitt und einem dritten Leitungsabschnitt der Substratmetallisierung, welche auf gegenüberliegenden Seiten des ersten Halbleiterelements angeordnet sind, verbunden. Während eines Betriebes der Halbleiteranordnung fließt ein Strom, insbesondere Laststrom, über den zweiten Leitungsabschnitt, die Verdrahtungselemente und den dritten Leitungsabschnitt. Fließt der Strom, insbesondere Laststrom, durch die Verdrahtungselemente, wirkt eine Scherkraft auf Verbindungen, insbesondere Ultraschall-Bondverbindungen, zwischen der Kontaktfläche des Halbleiterelements und den jeweiligen Verdrahtungselementen. Fließen unterschiedliche Ströme über die Verdrahtungselemente, wirken unterschiedliche Scherkräfte auf die Verbindungen, wobei die Scherkräfte bei höheren Strömen größer sind und es früher zu einer Ablösung des Verdrahtungselements kommen kann. Die Stromaufteilung wird unter anderem durch Verdrahtungsimpedanzen der Verdrahtungselemente und Leitungsimpedanzen der Leitungsabschnitte, insbesondere zwischen den Verdrahtungselementen, beeinflusst.

Um eine möglichst gleichmäßige Stromaufteilung zu erreichen, wird der Strom einseitig auf diagonal gegenüberliegenden Seiten des zweiten und dritten Leitungsabschnitts zu- bzw. abgeführt. Unter einer einseitigen Zu- bzw. Abführung ist in diesem Zusammenhang zu verstehen, dass der Strom zuerst über eine Verbindung eines der äußersten Verdrahtungselemente mit dem jeweiligen Leitungsabschnitt fließt. Unter einer einseitig auf diagonal gegenüberliegenden Seiten erfolgenden Zu- bzw. Abführung des Stromes ist in diesem Kontext somit zu verstehen, dass der Strom zuerst über eine Verbindung eines äußersten Verdrahtungselements mit einem Leitungsabschnitt zufließt und über eine Verbindung des gegenüberliegenden äußersten Verdrahtungselements mit dem auf der anderen Seite des ersten Halbleiterelements angeordnet Leitungsabschnitts abfließt. Somit fließt der Strom in jedem Pfad, welcher über eines der Verdrahtungselemente generiert wird, über eine sehr ähnliche, insbesondere im Wesentlichen gleiche, Impedanz, welche sich aus der Summe der jeweiligen Verdrahtungs- und Leitungsimpedanzen zusammensetzt, wodurch der Strom zumindest annähernd gleichmäßig auf die Verdrahtungselemente aufgeteilt wird. Auf diese Weise werden die Verbindungen der Verdrahtungselemente mit dem Halbleiterelement im Wesentlichen gleichmäßig belastet, was zu einer verbesserten Zuverlässigkeit der Halbleiteranordnung führt.

Ein Computerprogrammprodukt, welches Befehle umfasst, die bei einer Ausführung des Programms durch einen Computer diesen veranlassen, ein, insbesondere thermisches, mechanisches und oder elektrisches, Verhalten der beschriebenen Halbleiteranordnung zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der Offenbarungsgehalt von US 2017/0286572 A1 wird durch Verweisung in die vorliegende Anmeldung mit einbezogen. Der "digitale Zwilling" ist beispielsweise eine digitale Repräsentanz der für den Betrieb der Halbleiteranordnung relevanten Komponenten.

Eine weitere Ausführungsform sieht vor, dass der zweite Leitungsabschnitt und der dritte Leitungsabschnitt zwischen den Verdrahtungselementen jeweils Leitungsimpedanzen aufweisen, wobei die Leitungsimpedanzen der Leitungsabschnitte jeweils so dimensioniert sind, dass der Strom gleichmäßig auf die Verdrahtungselemente aufgeteilt ist. Beispielsweise weisen die Leitungsimpedanzen der Leitungsabschnitte eine resistive Komponente, insbesondere einen Serienwiderstand, eine induktive Komponente und/oder eine kapazitive Komponente auf. Bei einer vereinfachten Betrachtung kann die Leitungsimpedanz als ein Serienwiderstand oder als ein Serienwiderstand mit einer Serieninduktivität, betrachtet werden. Eine Dimensionierung der Leitungsimpedanzen kann unter anderem durch Anpassung der Position und/oder Geometrie der Leitungsabschnitte erfolgen. Durch eine derartige Dimensionierung der Leitungsimpedanzen wird der Strom gleichmäßig auf die Verdrahtungselemente aufgeteilt, was zu einer verbesserten Zuverlässigkeit der Halbleiteranordnung führt.

Eine weitere Ausführungsform sieht vor, dass die Verdrahtungselemente, insbesondere geradlinig, parallel verlaufend angeordnet sind. Durch eine derartige Anordnung wird eine gleichmäßige Stromführung bei gleichzeitig geringem Platzbedarf erreicht.

Eine weitere Ausführungsform sieht vor, dass ein erstes Verdrahtungselement und ein zweites Verdrahtungselement jeweils elektrisch und mechanisch mit dem zweiten Leitungsabschnitt, der Kontaktfläche des ersten Halbleiterelements und dem dritten Leitungsabschnitt verbunden sind, wobei die Verdrahtungselemente jeweils über eine erste Verbindung mit dem zweiten Leitungsabschnitt und über eine zweite Verbindung mit dem dritten Leitungsabschnitt verbunden sind, wobei der zweite Leitungsabschnitt konfiguriert ist, dass der Strom in eine erste Stromrichtung fließt, welche von der ersten Verbindung des ersten Verdrahtungselements zur ersten Verbindung des zweiten Verdrahtungselements verlaufend ausgeführt ist, wobei der dritte Leitungsabschnitt konfiguriert ist, dass der Strom in eine zweite Stromrichtung fließt, welche von der zweiten Verbindung des ersten Verdrahtungselements zur zweiten Verbindung des zweiten Verdrahtungselements verlaufend ausgeführt ist. Somit fließen die über das erste Verdrahtungselement und das zweite Verdrahtungselement fließenden Teilströme des Stromes über sehr ähnliche, insbesondere im Wesentlichen gleiche, Impedanzen, sodass zumindest annähernd eine gleichmäßige Stromverteilung erfolgt und die Verbindungen der Verdrahtungselemente mit dem Halbleiterelement im Wesentlichen gleichmäßig belastet werden, was zu einer verbesserten Zuverlässigkeit einer Halbleiteranordnung führt und dessen Lebensdauer verlängert.

Eine weitere Ausführungsform sieht vor, dass die zweite Stromrichtung im Wesentlichen der ersten Stromrichtung entspricht. Durch eine derartige Anordnung wird eine gleichmäßige Stromführung bei gleichzeitig geringem Platzbedarf erreicht.

Eine weitere Ausführungsform sieht vor, dass die erste Stromrichtung und die zweite Stromrichtung jeweils im Wesentlichen senkrecht zu zumindest einem Verdrahtungselement verlaufend ausgeführt sind. Durch eine derartige Anordnung wird, insbesondere bei parallel verlaufend angeordneten Verdrahtungselementen, eine gleichmäßige Stromführung bei gleichzeitig geringem Platzbedarf erreicht.

Eine weitere Ausführungsform sieht vor, dass zumindest eine erste Leitungsimpedanz des zweiten Leitungsabschnitts durch Variation der Breite angepasst ist. Eine derartige Variation ist einfach und platzsparend zu realisieren.

Eine weitere Ausführungsform sieht vor, dass die Halbleiteranordnung ein zweites Halbleiterelement aufweist, welches, insbesondere stoffschlüssig, mit dem zweiten Leitungsabschnitt verbunden ist und auf einer dem Substrat abgewandten Seite eine Kontaktfläche aufweist, wobei die Kontaktfläche des zweiten Halbleiterelements über weitere Verdrahtungselemente mit einem elektrisch isoliert angeordneten vierten Leitungsabschnitt der Substratmetallisierung verbunden ist, wobei der vierte Leitungsabschnitt unmittelbar an dem zweiten Leitungsabschnitt angrenzend angeordnet ist, wobei die erste Leitungsimpedanz des zweiten Leitungsabschnitts durch eine Position und/oder Geometrie des vierten Leitungsabschnitts dimensioniert ist. Unter unmittelbar angrenzend ist in diesem Zusammenhang zu verstehen, dass kein weiterer Leitungsabschnitt und keine elektrische Komponente, wie ein Halbleiterelement, zwischen dem vierten Leitungsabschnitt und dem zweiten Leitungsabschnitt angeordnet ist. Durch eine derartige Anordnung wird eine gleichmäßige Stromführung bei gleichzeitig geringem Platzbedarf erreicht.

Eine weitere Ausführungsform sieht vor, dass der vierte Leitungsabschnitt leerlaufend auf dem Substrat angeordnet ist. Eine leerlaufende Anordnung bedeutet, dass diese neben den weiteren Verdrahtungselementen mit keiner weiteren Komponente elektrisch leitend verbunden ist. Insbesondere fließt während des Betriebes der Halbleiteranordnung kein Strom über den vierten Leitungsabschnitt zu oder ab. Somit ist der vierte Leitungsabschnitt gleichzeitig zur Kompensation von Scherkräften, welche während eines Betriebes der Halbleiteranordnung auf die Verbindungen der weiteren Verdrahtungselemente mit der Kontaktfläche des zweiten Halbleiterelements wirken, als auch zur Einstellung der ersten Leitungsimpedanz des zweiten Leitungsabschnitts geeignet. Daher wird neben einer Verlängerung der Lebensdauer der Halbleiteranordnung zusätzlich eine Verringerung des Platzbedarfs erreicht.

Eine weitere Ausführungsform sieht vor, dass der vierte Leitungsabschnitt zumindest eine Schmalseite und eine Langseite aufweist, wobei eine Langseite des vierten Leitungsabschnitts unmittelbar an dem zweiten Leitungsabschnitt angrenzend angeordnet ist. Somit ist die erste Leitungsimpedanz des zweiten Leitungsabschnitts durch die Länge des angrenzenden Bereichs über einen weiten Bereich variierbar.

Eine weitere Ausführungsform sieht vor, dass die Kontaktfläche des zweiten Halbleiterelements über die weiteren Verdrahtungselemente mit einem elektrisch isoliert angeordneten fünften Leitungsabschnitt der Substratmetallisierung verbunden ist, wobei der vierte Leitungsabschnitt und der fünfte Leitungsabschnitt auf gegenüberliegenden Seiten des zweiten Halbleiterelements angeordnet sind. Durch die zusätzliche Verbindung der weiteren Verdrahtungselemente mit dem, insbesondere leerlaufend angeordneten, vierten Leitungsabschnitt, was auch "Überbonden" genannt wird, wirkt auch beim zweiten Halbleiterelement eine Gegenkraft den während des Betriebes auf die Verbindungen der weiteren Verdrahtungselemente mit der Kontaktfläche des Halbleiterelements wirkenden Scherkräfte entgegen. Somit sind die Verbindungen der weiteren Verdrahtungselemente mit der Kontaktfläche, insbesondere unter Last, robuster, was sich positiv auf die Zuverlässigkeit der Halbleiteranordnung auswirkt und dessen Lebensdauer verlängert.

Eine weitere Ausführungsform sieht vor, dass die Verdrahtungselemente und die weiteren Verdrahtungselemente im Wesentlichen parallel verlaufend angeordnet sind. Durch eine derartige Anordnung wird eine gleichmäßige Stromführung bei gleichzeitig geringem Platzbedarf erreicht.

Eine weitere Ausführungsform sieht vor, dass das erste Halbleiterelement als High Side Schalter und das zweite Halbleiterelement als Low Side Schalter einer Halbbrücke ausgeführt sind. Eine derartige Anordnung ermöglicht ein kompaktes Layout, was sich positiv auf den Platzbedarf auswirkt, eine optimierte Stromführung der Halbbrücke und, insbesondere bei einem Überbonden des ersten und zweiten Halbleiterelements eine gleichmäßige Auslastung und damit eine verlängerte Lebensdauer der Halbleiteranordnung.

Im Folgenden wird die Erfindung anhand der in den Figuren dargestellten Ausführungsbeispiele näher beschrieben und erläutert.

Es zeigen:

FIG 1 eine schematische Darstellung einer ersten Ausführungsform einer Halbleiteranordnung in einer Draufsicht,

FIG 2 ein vereinfachtes Ersatzschaltbild der ersten Ausführungsform der Halbleiteranordnung,

FIG 3 eine schematische Darstellung einer zweiten Ausführungsform einer Halbleiteranordnung in einer Draufsicht,

FIG 4 eine schematische Darstellung einer dritten Ausführungsform einer Halbleiteranordnung in einer Draufsicht,

FIG 5 eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

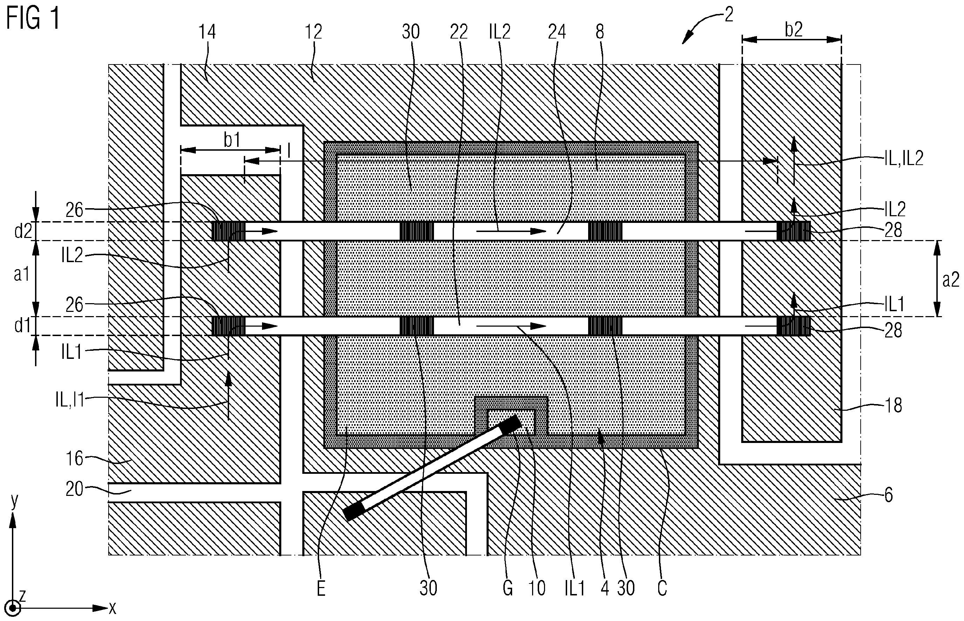

FIG 1 zeigt eine schematische Darstellung einer ersten Ausführungsform einer Halbleiteranordnung 2 in einer Draufsicht, welche ein erstes Halbleiterelement 4 umfasst, das auf einem Substrat 6 kontaktiert ist. Beispielhaft ist das erste Halbleiterelement 4 als ein vertikaler Transistor, insbesondere ein Insulated-Gate-Bipolar-Transistor (IGBT), ausgeführt. Weitere Beispiele für derartige Halbleiterelemente sind Triacs, Thyristoren, Dioden oder andere Transistortypen wie Feldeffekttransistoren oder Biploartransistoren. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind, wobei der Kollektor-Anschluss C, auf einer dem ersten Substrat 6 zugewandten Seite des ersten Halbleiterelements 4 stoffschlüssig, mit dem ersten Substrat 6 verbunden ist.

Der Emitter-Anschluss E weist eine Kontaktfläche 8 auf, wobei der Gate-Anschluss G eine von der Kontaktfläche 8 des Emitter-Anschlusses E elektrisch isoliert angeordnete Steuerkontaktfläche 10 aufweist. Die Kontaktfläche 8 und die Steuerkontaktfläche 10 weisen zumindest eine metallische Schicht auf, welche beispielsweise Aluminium, Kupfer und/oder Gold enthält. Der Kollektor-Anschluss C des IGBTs ist stoffschlüssig, beispielsweise über eine Löt- oder Sinterverbindung, mit einem ersten Leitungsabschnitt 12 einer Substratmetallisierung 14 des Substrats 6 verbunden. Die Substratmetallisierung 14 enthält beispielsweise Kupfer und ist strukturiert ausgeführt, wobei eine im Wesentlichen ebene Oberfläche der Substratmetallisierung 14 eine xy-Ebene definiert. Ein zweiter Leitungsabschnitt 16 und ein dritter Leitungsabschnitt 18 der Substratmetallisierung 14 sind auf gegenüberliegenden Seiten des ersten Halbleiterelements 4 angeordnet, wobei die Leitungsabschnitte 12, 16, 18 voneinander elektrisch isoliert angeordnet sind. Ferner umfasst das Substrat 6 eine dielektrische Materiallage 20, die beispielsweise einen keramischen Werkstoff, insbesondere Aluminiumnitrid oder Aluminiumoxid, enthält. Die dielektrische Materiallage 20 des Substrats 6 weist eine Stärke von 25 $\mu$m bis 400 $\mu$m, insbesondere 50 $\mu$m bis 250 pm, auf. Das Substrat 6 kann unter anderem als ein DCB (Direct Copper Bonded) Substrat, ausgeführt sein.

Beispielhaft zwei Verdrahtungselemente 22, 24, die als Bonddrähte ausgeführt sind, sind jeweils elektrisch und mechanisch mit dem zweiten Leitungsabschnitt 16, der Kontaktfläche 8 des ersten Halbleiterelements 4 und dem dritten Leitungsabschnitt 18 verbunden sind, wobei über die Verdrahtungselemente 22, 24 eine Verbindung des Emitters E des ersten Halbleiterelements 4 mit dem Substrat 6 hergestellt wird. Die Verdrahtungselemente 22, 24 sind jeweils über eine erste Verbindung 26 mit dem zweiten Leitungsabschnitt 16 und über eine zweite Verbindung 28 mit dem dritten Leitungsabschnitt 18 verbunden. Die Verdrahtungselemente 22, 24 bilden ferner auf der Kontaktfläche 8 des ersten Halbleiterelements 4 eine Mehrzahl von Chip-Verbindungen 30 aus, wobei die Verdrahtungselemente 22, 24 mittels Ultraschall-Bonden mit dem ersten Halbleiterelement 4 und dem Substrat 6 verbunden werden. Die Chip-Verbindungen 30 zur Kontaktfläche 8 des ersten Halbleiterelements 4 werden mittels Durchschleifen des jeweiligen Verdrahtungselements 22, 24, insbesondere mittels Multi-Stitch Wedge-to-Wedge-Wirebonding, hergestellt. Das mehrfache Bonden wird auch "Stitchen" genannt. Üblicherweise werden derartige Chip-Verbindungen 30 auch als "Stitchkontakte" bzw. "Stitchbonds" bezeichnet und können z.B. als "Wedgebonds" ausgeführt sein.

Der zweite Leitungsabschnitt 16 ist beispielhaft L-förmig ausgeführt und im Bereich der ersten Verbindungen 26 der Verdrahtungselemente 22, 24 gerade in y-Richtung verlaufend ausgeführt, sodass ein Laststrom IL in eine erste Stromrichtung I1 fließt, welche von der ersten Verbindung 26 des ersten Verdrahtungselements 22 zur ersten Verbindung 26 des zweiten Verdrahtungselements 24 verläuft. Beispielhaft verläuft die erste Stromrichtung I1 in y-Richtung und somit senkrecht zu den in x-Richtung verlaufend angeordneten Verdrahtungselementen 22, 24. Der Laststrom IL wird aufgrund der L-förmigen Ausführung des zweiten Leitungsabschnitts 16 in x-Richtung zugeführt, bevor dieser im Bereich der ersten Verbindungen 26 der Verdrahtungselemente 22, 24 gerade in y-Richtung fließt. Alternativ kann der zweite Leitungsabschnitt 16 I-förmig ausgeführt sein, wobei bei dieser Ausführung der Laststrom IL in y-Richtung zugeführt wird.

Der dritte Leitungsabschnitt 18 ist beispielhaft I-förmig ausgeführt und gerade in y-Richtung verlaufend ausgeführt, sodass der Laststrom IL in eine zweite Stromrichtung I2 fließt, welche von der zweiten Verbindung 28 des ersten Verdrahtungselements 22 zur zweiten Verbindung 28 des zweiten Verdrahtungselements 24 verläuft. Genau wie die erste Stromrichtung I1 verläuft die zweite Stromrichtung I2 in y-Richtung. Insbesondere entspricht die zweite Stromrichtung I2 im Wesentlichen der ersten Stromrichtung I1. Der Laststrom IL wird somit einseitig auf gegenüberliegenden Seiten über den zweiten Leitungsabschnitt 16 zu- und über den dritten Leitungsabschnitt 18 abgeführt.

Im Bereich der Verbindungen 26, 28 der Verdrahtungselemente 22, 24 weisen der zweite Leitungsabschnitt 16 und der dritte Leitungsabschnitt 18 jeweils dieselbe Breite b1, b2 auf. Ferner sind die Verdrahtungselemente 22, 24 geradlinig in x-Richtung und parallel verlaufend angeordnet, sodass ein erster Abstand a1 zwischen den ersten Verbindungen 26 auf dem zweiten Leitungsabschnitt 16 und ein zweiter Abstand a2 zwischen den zweiten Verbindungen 28 auf dem zweiten Leitungsabschnitt 16 im Wesentlichen gleich groß sind. Somit sind die Leitungsimpedanzen zwischen den Verdrahtungselementen 22, 24 des zweiten Leitungsabschnitts 16 und des dritten Leitungsabschnitts 18 im Wesentlichen gleich.

Da die parallel verlaufend angeordneten Verdrahtungselemente 22, 24 gleiche Verdrahtungsdurchmesser d1, d2 und im Wesentlichen gleiche Verdrahtungslängen l aufweisen, sind die Verdrahtungsimpedanzen der Verdrahtungselemente 22, 24 im Wesentlichen gleich groß und der Laststrom IL wird gleichmäßig auf die beispielhaft zwei Verdrahtungselemente 22, 24 aufgeteilt. Für eine gleichmäßige Aufteilung des Laststromes IL, beispielsweise bei unterschiedlichen Verdrahtungslängen l und/oder nicht parallel verlaufenden Verdrahtungselementen 22, 24, kann unter anderem die Leitungsimpedanz des zweiten Leitungsabschnitts 16, z.B. durch Variation der ersten Breite b1, angepasst werden.

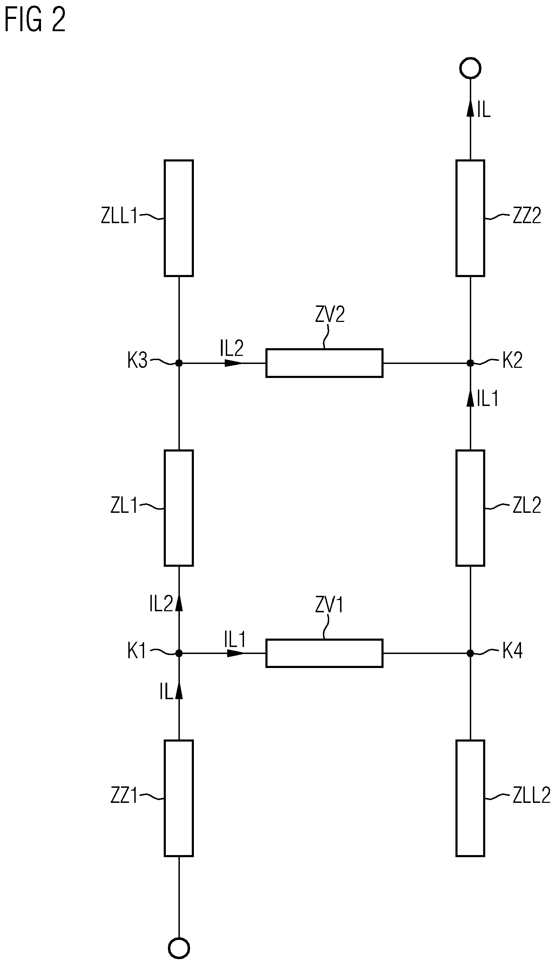

FIG 2 zeigt ein vereinfachtes Ersatzschaltbild der ersten Ausführungsform der Halbleiteranordnung, welche den in FIG 1 beschriebenen Zusammenhang illustriert. Es werden die Verdrahtungsimpedanzen ZV1, ZV2 der Verdrahtungselemente 22, 24 sowie die Leitungsimpedanzen ZL1, ZL2 des zweiten und des dritten Leitungsabschnitts 16, 18 zwischen den jeweiligen Verbindungen der Verdrahtungselemente 22, 24 gezeigt. Ferner sind die Zuleitungsimpedanzen ZZ1, ZZ2 des ersten und des zweiten Leitungsabschnitts 16, 18 sowie Leerlaufimpedanzen ZLL1, ZLL2 der leerlaufenden Leitungsabschnitte des zweiten und des dritten Leitungsabschnitts 16, 18 dargestellt. Ein erster Knoten K1 befindet sich an der Stelle, an der ein erster Laststrom IL1 über das erste Verdrahtungselement 22 abgezweigt wird, während ein zweiter Laststrom IL2 über den zweiten Leitungsabschnitt 16 zum zweiten Verdrahtungselement 24 fließt. Dementsprechend befindet sich ein zweiter Knoten K2 an der Stelle, an welcher der erste Laststrom IL1 vom dritten Leitungsabschnitt 18 und der zweite Laststrom IL2 vom zweiten Verdrahtungselement 24 zusammengeführt werden. Eine Zuführung kann analog über den zweiten Knoten K2 erfolgen. Beispielsweise können die Impedanzen eine resistive Komponente, insbesondere einen Serienwiderstand, eine induktive Komponente und/oder eine kapazitive Komponente aufweisen.

Der Laststrom IL fließt einseitig, das heißt über jeweils nur einen Knoten K1, K2, K3, K4, sowie über diagonal gegenüberliegende Knoten K1, K2; K3, K4 zu- bzw. ab. Dass zusätzlich die Summe der jeweiligen Verdrahtungsimpedanzen ZV1, ZV2 und Leitungsimpedanzen ZL1, ZL2 sehr ähnlich, insbesondere im Wesentlichen gleich, sind, das heißt:

$$ZL1 + ZV2 = ZV1 + ZL2,$$

führt zu einer gleichmäßigen Stromaufteilung:

$$IL1 = IL2 = IL/2.$$

Es ergibt sich im vereinfachten Ersatzschaltbild ein im Wesentlichen Z-förmiger Stromfluss.

Bei im Wesentlichen gleichen Verdrahtungsimpedanzen ZV1, ZV2, was sich bei parallel verlaufenden und gleich langen Verdrahtungselementen 22, 24 gleichen Durchmessers, wie in FIG 1 gezeigt, ergibt, sind die Leitungsimpedanzen ZL1, ZL2 ebenfalls im Wesentlichen gleich zu dimensionieren.

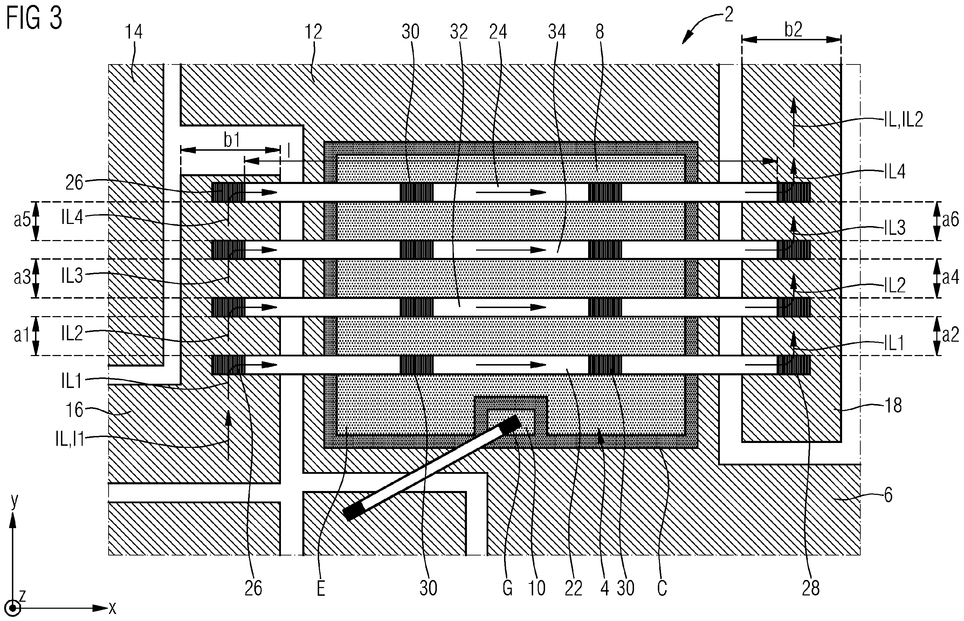

FIG 3 zeigt eine schematische Darstellung einer zweiten Ausführungsform einer Halbleiteranordnung in einer Draufsicht, wobei die Kontaktfläche 8 des ersten Halbleiterelements 4 über beispielhaft vier geradlinig in x-Richtung und parallel verlaufend angeordnete Verdrahtungselemente 22, 24, 32, 34 mit dem zweiten Leitungsabschnitt 16 und dem dritten Leitungsabschnitt 18 verbunden ist. Wie in FIG 1 gezeigt, weisen die Verdrahtungselemente 22, 24, 32, 34 gleiche Verdrahtungsdurchmesser und im Wesentlichen gleiche Verdrahtungslängen l auf. Die Abstände a1, a2, a3, a4, a5, a6 zwischen den parallel verlaufend angeordneten Verdrahtungselementen 22, 24, 32, 34 sind im Wesentlichen gleich groß, wobei der zweite Leitungsabschnitt 16 und der dritte Leitungsabschnitt 18 im Bereich der Verbindungen 26, 28 der Verdrahtungselement 22, 24, 32, 34 jeweils dieselbe Breite b1, b2 aufweisen. Der einseitig zu- bzw. abgeführte Strom IL wird gleichmäßig auf die Verdrahtungselemente 22, 24, 32, 34 aufgeteilt:

$$IL1=IL2=\ IL3=IL4=IL/4.$$

Die weitere Ausführung der Halbleiteranordnung 2 in FIG 3 entspricht der in FIG 1 bzw. FIG 2.

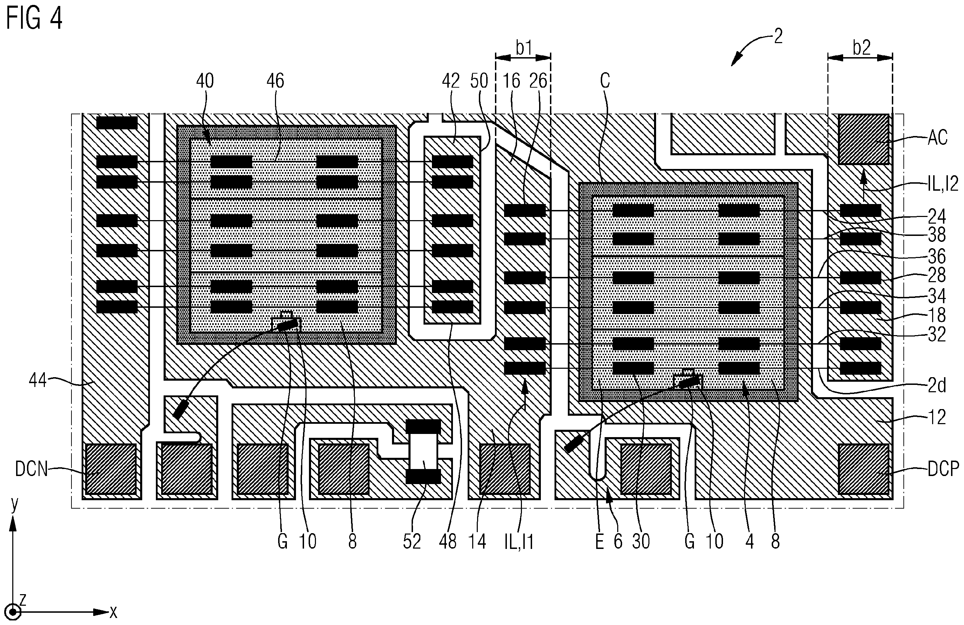

FIG 4 zeigt eine schematische Darstellung einer dritten Ausführungsform einer Halbleiteranordnung 2 in einer Draufsicht, wobei die Kontaktfläche 8 des ersten Halbleiterelements 4 über beispielhaft sechs geradlinig in x-Richtung und parallel verlaufend angeordnete Verdrahtungselemente 22, 24, 32, 34, 36, 38 mit dem zweiten Leitungsabschnitt 16 und dem dritten Leitungsabschnitt 18 verbunden ist. Wie in FIG 1 gezeigt, weisen die Verdrahtungselemente 22, 24, 32, 34, 36, 38 gleiche Verdrahtungsdurchmesser und im Wesentlichen gleiche Verdrahtungslängen auf. Die Abstände zwischen den parallel verlaufend angeordneten Verdrahtungselementen 22, 24, 32, 34, 36, 38 sind im Wesentlichen gleich groß, wobei der zweite Leitungsabschnitt 16 und der dritte Leitungsabschnitt 18 im Bereich der Verbindungen 26, 28 der Verdrahtungselement 22, 24, 32, 34, 36, 38 jeweils dieselbe Breite b1, b2 aufweisen. Der einseitig zu- bzw. abgeführte Strom IL wird gleichmäßig auf die Verdrahtungselemente 22, 24, 32, 34, 36, 38 aufgeteilt.

Die Halbleiteranordnung 2 weist darüber hinaus ein zweites Halbleiterelement 40 auf, welches, insbesondere stoffschlüssig, mit dem zweiten Leitungsabschnitt 16 verbunden ist und auf einer dem Substrat 6 abgewandten Seite eine Kontaktfläche 8 aufweist. Ein vierter Leitungsabschnitt 42 und ein fünfter Leitungsabschnitt 44 der Substratmetallisierung 14 sind auf gegenüberliegenden Seiten des zweiten Halbleiterelements 40 angeordnet, wobei die Kontaktfläche 8 des zweiten Halbleiterelements 40 über weitere Verdrahtungselemente 46 mit dem vierten Leitungsabschnitt 42 und dem fünften Leitungsabschnitt 44 verbunden ist. Der vierte Leitungsabschnitt 42 ist leerlaufend ausgeführt und unmittelbar an dem zweiten Leitungsabschnitt 16 angrenzend angeordnet. Beispielhaft weist der vierte Leitungsabschnitt 42 eine im Wesentlichen rechteckige Außenkontur mit einer Schmalseite 48 und einer Langseite 50 auf, wobei eine Langseite 50 des vierten Leitungsabschnitts 42 unmittelbar an dem zweiten Leitungsabschnitt 16 angrenzend angeordnet ist. Durch Variation der Position und/oder der Geometrie des vierten Leitungsabschnitts 42 ist die erste Breite b1 des zweiten Leitungsabschnitts 16 variierbar. Somit ist die erste Leitungsimpedanz ZL1 des zweiten Leitungsabschnitts 16 durch die Position und/oder die Geometrie des vierten Leitungsabschnitts 42 dimensionierbar.

Beispielhaft sind das erste Halbleiterelement 4 als High Side Schalter und das zweite Halbleiterelement 40 als Low Side Schalter einer Halbbrücke ausgeführt. Dabei ist der fünfte Leitungsabschnitt 44 mit einem negativen DC-Anschluss DCN der Halbbrücke verbunden ist, während der erste Leitungsabschnitt 12 mit einem positiven DC-Anschluss DCP und der dritte Leitungsabschnitt 18 mit einem AC-Anschluss AC der Halbbrücke verbunden ist. Ferner umfasst die Halbleiteranordnung 2 einen Sensor 52, insbesondere einen Temperatursensor, der beispielsweise als NTC-Thermistor (Negative Temperature Coefficient Thermistor) ausgeführt ist. Der Sensor 52 ist im Bereich der Halbleiterelemente 4, 40 angeordnet. Die weitere Ausführung der Halbleiteranordnung 2 in FIG 4 entspricht der in FIG 3.

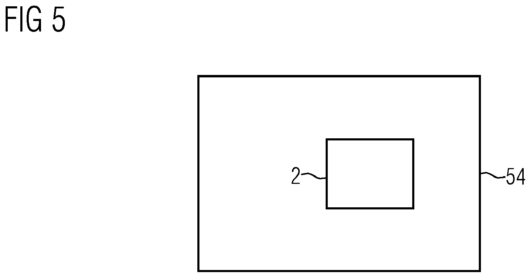

FIG 5 zeigt eine schematische Darstellung eines Stromrichters 54, welcher beispielhaft eine Halbleiteranordnung 2 umfasst.

Zusammenfassend betrifft die Erfindung eine Halbleiteranordnung 2 mit einem ersten Halbleiterelement 4 und einem Substrat 6, wobei das Substrat 6 eine Substratmetallisierung 14 mit voneinander elektrisch isoliert angeordneten Leitungsabschnitten 12, 16, 18, 42, 44 aufweist, wobei das erste Halbleiterelement 4, insbesondere stoffschlüssig, mit einem ersten Leitungsabschnitt 12 der Substratmetallisierung 14 verbunden ist, wobei das erste Halbleiterelement 4 auf einer dem Substrat 6 abgewandten Seite eine Kontaktfläche 8 aufweist, wobei ein zweiter Leitungsabschnitt 16 und ein dritter Leitungsabschnitt 18 der Substratmetallisierung 14 auf gegenüberliegenden Seiten des ersten Halbleiterelements 4 angeordnet sind, wobei Verdrahtungselemente 22, 24, 32, 34, 36, 38 jeweils elektrisch und mechanisch mit dem zweiten Leitungsabschnitt 16, der Kontaktfläche 8 des ersten Halbleiterelements 4 und dem dritten Leitungsabschnitt 18 verbunden sind. Um eine verbesserte Zuverlässigkeit zu erreichen, wird vorgeschlagen, dass der zweite Leitungsabschnitt 16 und der dritte Leitungsabschnitt 18 so konfiguriert sind, dass ein während eines Betriebes der Halbleiteranordnung 2 zwischen dem zweiten Leitungsabschnitt 16 und dem dritten Leitungsabschnitt 18 über die Verdrahtungselemente 22, 24, 32, 34, 36, 38 fließender Strom IL einseitig auf diagonal gegenüberliegenden Seiten zu- bzw. abfließt.

**Patentansprüche**

1. Halbleiteranordnung (2) mit einem ersten Halbleiterelement (4) und einem Substrat (6),

   wobei das Substrat (6) eine Substratmetallisierung (14) mit voneinander elektrisch isoliert angeordneten Leitungsabschnitten (12, 16, 18, 42, 44) aufweist,
   wobei das erste Halbleiterelement (4), insbesondere stoffschlüssig, mit einem ersten Leitungsabschnitt (12) der Substratmetallisierung (14) verbunden ist,
   wobei das erste Halbleiterelement (4) auf einer dem Substrat (6) abgewandten Seite eine Kontaktfläche (8) aufweist, wobei ein zweiter Leitungsabschnitt (16) und ein dritter Leitungsabschnitt (18) der Substratmetallisierung (14) auf gegenüberliegenden Seiten des ersten Halbleiterelements (4) angeordnet sind,
   wobei Verdrahtungselemente (22, 24, 32, 34, 36, 38) jeweils elektrisch und mechanisch mit dem zweiten Leitungsabschnitt (16), der Kontaktfläche (8) des ersten Halbleiterelements (4) und dem dritten Leitungsabschnitt (18) verbunden sind,
   wobei der zweite Leitungsabschnitt (16) und der dritte Leitungsabschnitt (18) so konfiguriert sind, dass ein während eines Betriebes der Halbleiteranordnung (2) zwischen dem zweiten Leitungsabschnitt (16) und dem dritten Leitungsabschnitt (18) über die Verdrahtungselemente (22, 24, 32, 34, 36, 38) fließender Strom (IL) einseitig auf diagonal gegenüberliegenden Seiten zu- bzw. abfließt.

2. Halbleiteranordnung (2) nach Anspruch 1,

   wobei der zweite Leitungsabschnitt (16) und der dritte Leitungsabschnitt (18) zwischen den Verdrahtungselementen (22, 24, 32, 34, 36, 38) jeweils Leitungsimpedanzen (ZL1, ZL2) aufweisen,
   wobei die Leitungsimpedanzen (ZL1, ZL2) der Leitungsabschnitte (16, 18) jeweils so dimensioniert sind, dass der Strom (IL) gleichmäßig auf die Verdrahtungselemente (22, 24, 32, 34, 36, 38) aufgeteilt ist.

3. Halbleiteranordnung (2) nach einem der Ansprüche 1 oder 2, wobei die Verdrahtungselemente (22, 24, 32, 34, 36, 38), insbesondere geradlinig, parallel verlaufend angeordnet sind.

4. Halbleiteranordnung (2) nach einem der Ansprüche 1 bis 3,

   wobei ein erstes Verdrahtungselement (22) und ein zweites Verdrahtungselement (24) jeweils elektrisch und mechanisch mit dem zweiten Leitungsabschnitt (16), der Kontaktfläche (8) des ersten Halbleiterelements (4) und dem dritten Leitungsabschnitt (18) verbunden sind,
   wobei die Verdrahtungselemente (22, 24) jeweils über eine erste Verbindung (26) mit dem zweiten Leitungsabschnitt (16) und über eine zweite Verbindung (28) mit dem dritten Leitungsabschnitt (18) verbunden sind,
   wobei der zweite Leitungsabschnitt (16) konfiguriert ist, dass der Strom (IL) in eine erste Stromrichtung (I1) fließt, welche von der ersten Verbindung (26) des ersten Verdrahtungselements (22) zur ersten Verbindung (26) des zweiten Verdrahtungselements (24) verlaufend ausgeführt ist,
   wobei der dritte Leitungsabschnitt (18) konfiguriert ist, dass der Strom (IL) in eine zweite Stromrichtung (I2) fließt, welche von der zweiten Verbindung (28) des ersten Verdrahtungselements (22) zur zweiten Verbindung (28) des zweiten Verdrahtungselements (24) verlaufend ausgeführt ist.

5. Halbleiteranordnung (2) nach Anspruch 4, wobei die zweite Stromrichtung (I2) im Wesentlichen der ersten Stromrichtung (I1) entspricht.

6. Halbleiteranordnung (2) nach einem der Ansprüche 4 oder 5, wobei die erste Stromrichtung (I1) und die zweite Stromrichtung (I2) jeweils im Wesentlichen senkrecht zu zumindest einem Verdrahtungselement (22, 24) verlaufend ausgeführt sind.

7. Halbleiteranordnung (2) nach einem der vorherigen Ansprüche, wobei zumindest eine erste Leitungsimpedanz (ZL1) des zweiten Leitungsabschnitts (16) durch Variation der Breite (b) angepasst ist.

8. Halbleiteranordnung (2) nach einem der vorherigen Ansprüche, welche ein zweites Halbleiterelement (40) aufweist, welches, insbesondere stoffschlüssig, mit dem zweiten Leitungsabschnitt (16) verbunden ist und auf einer dem Substrat (6) abgewandten Seite eine Kontaktfläche (8) aufweist, wobei die Kontaktfläche (8) des zweiten Halbleiterelements (40) über weitere Verdrahtungselemente (46) mit einem elektrisch isoliert angeordneten vierten Leitungsabschnitt (42) der Substratmetallisierung (14) verbunden ist, wobei der vierte Leitungsabschnitt (42) unmittelbar an dem zweiten Leitungsabschnitt (16) angrenzend angeordnet ist, wobei die erste Leitungsimpedanz (ZL1) des zweiten Leitungsabschnitts (16) durch eine Position und/oder Geometrie des vierten Leitungsabschnitts (42) dimensioniert ist.

9. Halbleiteranordnung (2) nach Anspruch 8, wobei der vierte Leitungsabschnitt (42) leerlaufend auf dem Substrat (6) angeordnet ist.

10. Halbleiteranordnung (2) nach einem der Ansprüche 8 oder 9,

   wobei der vierte Leitungsabschnitt (42) zumindest eine Schmalseite (48) und eine Langseite (50) aufweist, wobei eine Langseite (50) des vierten Leitungsabschnitts (42) unmittelbar an dem zweiten Leitungsabschnitt (16) angrenzend angeordnet ist.

11. Halbleiteranordnung (2) nach einem der Ansprüche 8 bis 10, wobei die Kontaktfläche (8) des zweiten Halbleiterelements (40) über die weiteren Verdrahtungselemente (46) mit einem elektrisch isoliert angeordneten fünften Leitungsabschnitt (44) der Substratmetallisierung (14) verbunden ist, wobei der vierte Leitungsabschnitt (42) und der fünfte Leitungsabschnitt (44) auf gegenüberliegenden Seiten des zweiten Halbleiterelements (40) angeordnet sind.

12. Halbleiteranordnung (2) nach einem der Ansprüche 8 bis 11, wobei die Verdrahtungselemente (22, 24, 32, 34, 36, 38) und die weiteren Verdrahtungselemente (46) im Wesentlichen parallel verlaufend angeordnet sind.

13. Halbleiteranordnung (2) nach einem der Ansprüche 8 bis 12, wobei das erste Halbleiterelement (4) als High Side Schalter und das zweite Halbleiterelement (40) als Low Side Schalter einer Halbbrücke ausgeführt sind.

14. Stromrichter (54) mit mindestens einer Halbleiteranordnung (2) nach einem der vorherigen Ansprüche.

15. Verfahren zur Herstellung einer Halbleiteranordnung (2) mit einem ersten Halbleiterelement (4) und einem Substrat (6),

   wobei das Substrat (6) eine Substratmetallisierung (14) mit voneinander elektrisch isoliert angeordneten Leitungsabschnitten (12, 16, 18, 42, 44) aufweist, wobei das erste Halbleiterelement (4), insbesondere stoffschlüssig, mit einem ersten Leitungsabschnitt (12) der Substratmetallisierung (14) verbunden wird, wobei das erste Halbleiterelement (4) auf einer dem Substrat (6) abgewandten Seite eine Kontaktfläche (8) aufweist, wobei ein zweiter Leitungsabschnitt (16) und ein dritter Leitungsabschnitt (18) der Substratmetallisierung (14) auf gegenüberliegenden Seiten des ersten Halbleiterelements (4) angeordnet werden, wobei Verdrahtungselemente (22, 24, 32, 34, 36, 38) jeweils elektrisch und mechanisch mit dem zweiten Leitungsabschnitt (16), der Kontaktfläche (8) des ersten Halbleiterelements (4) und dem dritten Leitungsabschnitt (18) verbunden werden, wobei der zweite Leitungsabschnitt (16) und der dritte Leitungsabschnitt (18) so konfiguriert werden, dass ein während eines Betriebes der Halbleiteranordnung (2) zwischen dem zweiten Leitungsabschnitt (16) und dem dritten Leitungsabschnitt (18) über die Verdrahtungselemente (22, 24, 32, 34, 36, 38) fließender Strom (IL) einseitig auf diagonal gegenüberliegenden Seiten zu- bzw. abfließt.

16. Verfahren nach Anspruch 15

   wobei der zweite Leitungsabschnitt (16) und der dritte Leitungsabschnitt (18) zwischen den Verdrahtungselementen (22, 24, 32, 34, 36, 38) jeweils Leitungsimpedanzen (ZL1, ZL2) aufweisen, wobei die Leitungsimpedanzen (ZL1, ZL2) der Leitungsabschnitte (16, 18) jeweils so dimensioniert werden, dass der Strom (IL) gleichmäßig über die Verdrahtungselemente (22, 24, 32, 34, 36, 38) fließt.

17. Computerprogrammprodukt, umfassend Befehle, die bei einer Ausführung des Programms durch einen Computer diesen veranlassen, ein, insbesondere elektrisches, mechanisches und/oder thermisches, Verhalten einer Halbleiteranordnung (2) nach einem der Ansprüche 1 bis 13 zu simulieren.

FIG 1

FIG 2

# FIG 3

FIG 4

FIG 5

2 ～ 　　　～ 54

Europäisches Patentamt

European Patent Office

Office européen des brevets

**EUROPÄISCHER RECHERCHENBERICHT**

Nummer der Anmeldung

EP 23 21 3098

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 4 160 677 A1 (SIEMENS AG [DE]) 5. April 2023 (2023-04-05) | 1-5, 14-17 | INV. H01L23/00 |
| Y | * Zusammenfassung *; Ansprüche; Abbildungen 1,3 * * Absätze [0003], [0036] * | 6-13 | H01L23/373 H01L23/498 H01L23/538 H01L23/64 |
| X | US 2020/266240 A1 (MORISAKI SHOTA [JP] ET AL) 20. August 2020 (2020-08-20) | 1,3-5, 14,15,17 | H01L25/07 H01L25/18 |
| Y | * Zusammenfassung *; Ansprüche; Abbildung 15 * * Absatz [0188] * | 6-13 | H02M7/00 |
| X | US 2006/001146 A1 (PASSE THOMAS [DE] ET AL) 5. Januar 2006 (2006-01-05) | 1,3-5, 15,17 | |
| Y | * Zusammenfassung *; Ansprüche; Abbildung 2 * | 6-13 | |
| Y | EP 3 226 294 A1 (NISSAN MOTOR [JP]) 4. Oktober 2017 (2017-10-04) * Zusammenfassung *; Ansprüche; Abbildung 5 * | 6 | |
| Y | US 2020/185359 A1 (NAKASHIMA JUNICHI [JP] ET AL) 11. Juni 2020 (2020-06-11) * Zusammenfassung *; Ansprüche; Abbildungen 7-30 * * Absätze [0105] - [0112], [0217], [0218] * | 7-13 | RECHERCHIERTE SACHGEBIETE (IPC) H01L H02M |
| A | EP 3 480 846 A1 (INFINEON TECHNOLOGIES AG [DE]) 8. Mai 2019 (2019-05-08) * Zusammenfassung *; Ansprüche; Abbildungen * | 1-17 | |

Der vorliegende Recherchenbericht wurde für alle Patentansprüche erstellt

| Recherchenort | Abschlußdatum der Recherche | Prüfer |
|---|---|---|
| Den Haag | 17. Mai 2024 | Wirner, Christoph |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 21 3098

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-05-2024

| Im Recherchenbericht angeführtes Patentdokument | Datum der Veröffentlichung | Mitglied(er) der Patentfamilie | Datum der Veröffentlichung |
|---|---|---|---|
| EP 4160677 A1 | 05-04-2023 | EP 4160677 A1 | 05-04-2023 |
| | | EP 4367717 A1 | 15-05-2024 |
| | | WO 2023051981 A1 | 06-04-2023 |
| US 2020266240 A1 | 20-08-2020 | CN 110495087 A | 22-11-2019 |
| | | DE 112018002101 T5 | 20-02-2020 |
| | | JP 6912560 B2 | 04-08-2021 |
| | | JP WO2018193929 A1 | 26-12-2019 |
| | | US 2020266240 A1 | 20-08-2020 |
| | | WO 2018193929 A1 | 25-10-2018 |
| US 2006001146 A1 | 05-01-2006 | DE 102004027185 A1 | 29-12-2005 |
| | | US 2006001146 A1 | 05-01-2006 |
| EP 3226294 A1 | 04-10-2017 | CN 107155372 A | 12-09-2017 |
| | | EP 3226294 A1 | 04-10-2017 |
| | | JP 6288301 B2 | 14-03-2018 |
| | | JP WO2016084241 A1 | 26-10-2017 |
| | | US 2017345792 A1 | 30-11-2017 |
| | | WO 2016084241 A1 | 02-06-2016 |
| US 2020185359 A1 | 11-06-2020 | CN 111033735 A | 17-04-2020 |
| | | DE 112018004893 T5 | 10-06-2020 |
| | | JP 6865838 B2 | 28-04-2021 |
| | | JP WO2019044748 A1 | 02-07-2020 |
| | | US 2020185359 A1 | 11-06-2020 |
| | | WO 2019044748 A1 | 07-03-2019 |
| EP 3480846 A1 | 08-05-2019 | CN 109755228 A | 14-05-2019 |
| | | EP 3480846 A1 | 08-05-2019 |
| | | US 2019139880 A1 | 09-05-2019 |
| | | US 2020286820 A1 | 10-09-2020 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2022002464 A1

- US 20170286572 A1